# EUROPEAN PATENT APPLICATION

(11) **EP 1 024 564 A2**
(43) Date of publication of application: **02.08.2000**
(21) Application number: 00101590.8
(22) Date of filing: 27.01.2000
(51) Int. Cl.: H01S 5/026, H04B 10/145

(54) **Optical transmission system an optical transmitter**

(30) Priority: 29.01.1999 JP 2227999
(71) Applicant: Hitachi, Ltd., Chiyoda-ku, Tokyo 101-8010 (JP)
(72) Inventor: Aoki, Masahiro, C/O Hitachi, Ltd., Tokyo 100-8220 (JP)
(74) Representative: Strehl Schübel-Hopf & Partner

(57) **Abstract**

Disclosed herein are an optical transmission system having light sources for wavelength division multiplexing communication adapted to the standard wavelength channels and an optical transmitter having an external modulator monolithically integrated. The optical transmission system has an optical transmitter as a light source for optical signal. The optical transmitter includes a semiconductor waveguide region including a distributed reflection type first optical feedback device, an emission region, and an optical absorption region integrated together, and a second optical feedback device formed independently of the semiconductor waveguide region in opposed relationship to an end surface of the semiconductor waveguide region opposite to the first optical feedback device. Optical modulation is performed in the optical absorption region. With this configuration, long-haul wavelength division multiplexing transmission can be easily realized.

## Description

### BACKGROUND OF THE INVENTION

### Field of the Invention

The present invention relates generally to an optical communication system or an optical network, and more particularly to an optical transmitter for use in such an optical communication system or an optical network.

### Description of the Related Art

Wavelength division multiplexing optical communication capable of transmitting a plurality of optical signals having different wavelengths through a single optical transmission line is now increasingly important with a higher performance and lower cost of communication techniques and optical information processing techniques.

At present, the wavelengths or frequencies of operating channels in wavelength division multiplexing optical communication are predetermined with a frequency spacing of 100 GHz (or a wavelength spacing of about 0.8 nm) by the international standardization. Accordingly, one of the significant challenges is how to set the wavelength of a semiconductor laser device as a light source to a standard value at a high yield.

A conventional fabrication method for a light source for wavelength division multiplexing communication is to select a semiconductor light emitting element adapted to a standard wavelength from many semiconductor light emitting elements whose oscillation wavelengths are widely distributed with a tolerance of about ±3 nm. Accordingly, this conventional fabrication method requires much time and labor, and has a large problem in yield of the wavelengths of the semiconductor light emitting elements initially fabricated.

To solve such a problem, there has been proposed an external reflector laser device using both a semiconductor laser device having an antireflection coating at its incident end surface and an external Bragg reflector, for example. Known as an example of the external reflector laser device mentioned above is a surface mount type external reflector laser device configured by using a surface mount technology to optically couple a silica-based diffraction grating waveguide and a semiconductor laser section with an antireflection coating formed on a silicon (Si) substrate. An example of this kind of wavelength division multiplexing communication light source is described in Second Optoelectronics and Communications Conference, 1997 (OECC '97) 10D3-3.

To generate a modulated optical signal by using this laser device, direct modulation of the laser device must be basically performed, or the laser device must be combined with an external modulator. However, the former case causes a problem of wavelength chirping due to high-speed operation and direct modulation, and the latter case causes a problem of reduction in optical output due to multistage connection of the external modulator. The term of wavelength chirping means a fluctuation range of emission wavelengths in switching on and off the emission.

### SUMMARY OF THE INVENTION

It is accordingly an object of the present invention to provide an optical transmission system having a light source whose oscillation wavelength is stable. According to the present invention, light sources for wavelength division multiplexing communication adapted to the internal standard wavelength channels can be realized at a high yield by a simple method. The internal standard wavelength channels mean channels adapted to the ITU grid.

It is another object of the present invention to provide an optical transmitter whose oscillation wavelength is stable, having an external modulator monolithically integrated. According to the present invention, aged degradation in emission characteristics can be greatly reduced. Accordingly, the present invention is effective especially to a long-haul optical transmission system.

The present inventors have now proposed a modulator integrated compound cavity laser configured by combining a semiconductor waveguide laminate including an emission region (called also a gain region), first optical feedback means (e.g., distributed reflection type waveguide), and an optical absorption region formed in this order, and second optical feedback means (e.g., diffraction grating) formed outside of the semiconductor waveguide laminate. By using this laser, an optical transmission system and an optical transmitter which can achieve the objects of the present invention have also been proposed. The optical transmission system and the optical transmitter according to the present invention can easily realize wavelength division multiplexing transmission.

Some aspects of the present invention will now be described.

According to a first aspect of the present invention, there is provided an optical transmission system having an optical transmitter as a light source, said optical transmitter comprising a semiconductor waveguide region comprising distributed reflection type first optical feedback means, an emission region, and an optical absorption region integrated together; and second optical feedback means formed independently of said semiconductor waveguide region in opposed relationship to an end surface of said semiconductor waveguide region opposite to said first optical feedback means; optical modulation being performed in said optical absorption region.

With this configuration, it is possible to eliminate the defects of the conventional external reflector type laser device and ensure a stable oscillation wavelength and optical output.

Since the second optical feedback means is formed independently or separately of the semiconductor waveguide region, the width of a stop band of the second optical feedback means can be selected without limitation of the material of the semiconductor waveguide region. Accordingly, a deviation of the oscillation wavelength can be suppressed to such a degree as corresponding to the small stop band width.

The oscillation wavelengths of the emission region, the optical absorption region, and the first optical feedback means are set shorter in this order.

The second optical feedback means is able to be formed by a material having thermally more stable characteristic for such as its reflection characteristic than semiconductor materials. The most typical examples for the materials having thermally more stable characteristic are inorganic insulating materials, that is, SiO₂, SiN. On the other hand, the first optical feedback means is made of semiconductor material.

According to a second aspect of the present invention, there is provided an optical transmission system having a plurality of optical transmitters as light sources for wavelength division multiplexing of optical signals having at least two different wavelengths, each of said optical transmitters comprising a semiconductor waveguide region comprising distributed reflection type first optical feedback means, an emission region, and an optical absorption region integrated together; and second optical feedback means formed independently of said semiconductor waveguide region in opposed relationship to an end surface of said semiconductor waveguide region opposite to said first optical feedback means; optical modulation being performed in said optical absorption region.

With this configuration, the oscillation wavelength can be made greatly stable, and additionally to the effects of the first aspect, the optical transmission system according to the second aspect is effective as a wavelength division multiplexing optical communication system.

The wavelength division multiplexing optical communication system is a system for transmitting information by propagating optical signals having at least two different wavelengths through a single optical transmission line.

According to a third aspect of the present invention, the width of a stop band of said second optical feedback means is smaller than the width of a stop band of said first optical feedback means. The optical transmitter further comprises a given substrate on which the semiconductor waveguide region and the second optical feedback means are mounted.

Each of the first and second optical feedback means is preferably configured by a diffraction grating, and it is important to make the stop band width of the diffraction grating as the second optical feedback means much smaller than the stop band width of the diffraction grating as the first optical feedback means. Accordingly, a resultant compound cavity configured by the first optical feedback means, the emission region, and the second optical feedback means can oscillate at a wavelength limited by the small stop band width of the second optical feedback means. Accordingly, a deviation of the oscillation wavelength can be suppressed to a greatly small wavelength range.

A wavelength spacing region of a width of a stop band of an optical feedback means is able to be regarded as a kind of reflection mirror for a resonator in a classical optical model. An laser oscillation is caused as corresponding to a so-called reflection mirror having a smaller stop band width than a larger stop band width of another so-called facing reflection mirror. A stop band width means a wavelength region between a peak of the first transparent spectrum and a peak of the second transparent spectrum being near the first transparent spectrum. Either the peak of the first transparent spectrum or the peak of the second transparent spectrum of the second optical feedback means serves for an oscillation wavelength of the laser device. These two wavelengths which are at the both side of the stop band are closer together. Therefore, a deviation of the oscillation wavelength can be suppressed to a greatly small wavelength range.

Since the second optical feedback means is independent of the semiconductor waveguide region, a large difference in stop band width between the diffraction grating as the first optical feedback means and the diffraction grating as the second optical feedback means can be easily produced.

According to a fourth aspect of the present invention, there is provided an optical transmitter comprising a semiconductor waveguide region comprising distributed reflection type first optical feedback means, an emission region, and an optical absorption region integrated together; second optical feedback means formed independently of said semiconductor waveguide region in opposed relationship to an end surface of said semiconductor waveguide region opposite to said first optical feedback means; and a given substrate on which said semiconductor waveguide region and said second optical feedback means are mounted; optical modulation being performed in said optical absorption region; the width of a stop band of said second optical feedback means being smaller than the width of a stop band of said first optical feedback means.

With this configuration, the defects of the conventional external reflector type laser device can be eliminated, and a stable oscillation wavelength and optical output can be ensured.

It should be readily understood that the scope of any one of the first to third aspects of the present invention is suitably applicable to each component in the fourth aspect of the present invention.

According to a fifth aspect of the present invention, said semiconductor waveguide region is a laminate of semiconductor waveguides, said laminate having input and output ends at least one of which is provided with an optical waveguide having a spot enlarging function. The optical waveguide is monolithically integrated with the laminate.

The optical waveguide having the spot enlarging function may be configured by a so-called waveguide lens. By using the waveguide lens, the efficiency of optical coupling in the optical system can be greatly improved.

It should be readily understood that the scope of any one of the first to fourth aspects of the present invention is suitably applicable to each component in the fifth aspect of the present invention.

According to a sixth aspect of the present invention, the upper surface of the laminate on which the waveguide is formed has a positioning marker for positioning the optical axis of the laminate with respect to a mounting substrate. This marker is practically greatly useful for fabrication of the optical transmitter.

It should be readily understood that the optical transmitter according to any one of the fourth to sixth aspects of the present invention may be used as a wavelength division multiplexing light source for a wavelength division multiplexing optical communication device. Further, it should be readily understood that the application of the optical transmitter according to the present invention is not limited to optical transmission systems according to preferred embodiments to be hereinafter described.

### BRIEF DESCRIPTION OF THE DRAWINGS

FIG. 1 is a schematic sectional view for illustrating a preferred embodiment of the present invention;
FIG. 2 is a schematic perspective view for illustrating the preferred embodiment;
FIG. 3 is a plan view of a mask for forming a multi-quantum well laminate according to the present invention;
FIG. 4 is a sectional view showing a condition where the multi-quantum well laminate is formed on a semiconductor substrate;
FIG. 5 is a sectional view showing a condition where a diffraction grating is formed in the multi-quantum well laminate;
FIG. 6 is a sectional view showing a condition where a semiconductor laminate according to the present invention is formed;
FIG. 7 is a sectional view showing a semiconductor optical device according to the present invention;
FIG. 8 is a schematic block diagram showing a preferred embodiment of the wavelength division multiplexing optical transmission system according to the present invention;
FIG. 9 is a plan view of a wavelength division multiplexing optical transmitting section of the system shown in FIG. 8; and
FIG. 10 is a schematic block diagram showing an example of an optical communication system to which the present invention is applicable.

### DETAILED DESCRIPTION OF THE PREFERRED EMBODIMENTS

Prior to description of some preferred embodiments of the present invention, there will now be described a specific embodiment of the essential parts according to each aspect of the present invention in detail.

The semiconductor waveguide region having at least the distributed reflection type first optical feedback means, the emission region, and the optical absorption region is formed usually by integrating a plurality of multi-quantum well waveguides of semiconductor material in the form of laminate. Typically, the laminate of multi-quantum well waveguides is formed on an InP substrate or GaAs substrate by a known method. In general, in the case of using the InP substrate, the multi-quantum well waveguides are formed of a compound semiconductor material generally called an InP-based material such as InGaAsP or InGaAlAs, whereas in the case of using the GaAs substrate, the multi-quantum well waveguides are formed of a compound semiconductor material such as GaInNAs. Each waveguide itself may be configured by a known method according to the specifications of the optical transmitter.

The optical modulation in the optical absorption region is performed by utilizing a change in optical absorptivity of the optical absorption region according to an applied electric field. That is, a voltage is applied to the optical absorption region to perform the optical modulation. More practically, the optical absorption region is usually provided with two kinds of electrodes, and is divided into a first optical absorption region for optical modulation and a second optical absorption region for optical monitoring. While the second optical absorption region is used for optical monitoring, it is not essential. However, the use of the second optical absorption region is greatly practical because a photocurrent passing through the optical absorption region can be detected to allow control of an optical output. Accordingly, by adopting the above-mentioned specific configuration, both the oscillation wavelength and the optical output of the optical transmission system can be controlled.

The distributed reflection type first optical feedback means is configured by a diffraction grating provided in the semiconductor waveguide region. The second optical feedback means is also configured by a diffraction grating provided independently of the semiconductor waveguide region.

The optical axis of the semiconductor waveguide region is aligned with the optical axis of the second optical feedback means. A specific example of the second optical feedback means is a diffraction grating formed in a known silica optical waveguide. More specifically, the silica optical waveguide is composed of a silicon dioxide (SiO₂) substrate, a silicon nitride (SiN) layer formed on the silicon dioxide substrate, and a silicon dioxide layer formed on the silicon nitride layer. In some case, the silicon nitride layer is doped with a slight amount of Ge. The diffraction grating with desired characteristics is formed in the silicon nitride layer. Another material may be used as the material of the second optical feedback means.

In the case that the second optical feedback means is configured by a silica optical waveguide having a diffraction grating, the stop band width of the diffraction grating as the second optical feedback means can be easily made much smaller than the stop band width of the diffraction grating as the first optical feedback means provided in the semiconductor waveguide region. Accordingly, as described previously, the compound cavity composed of the first optical feedback means, the emission region, and the second optical feedback means can oscillate with limitation by the narrow stop band of the second optical feedback means, so that a deviation of the oscillation wavelength can be suppressed to a greatly small wavelength range. The stop band width of the diffraction grating of the semiconductor waveguide region is about 2 nm to about 20 nm, and the stop band width of the diffraction grating of the silica optical waveguide is about 0.3 nm to about 2 nm.

In the case that the second optical feedback means is configured by a silica optical waveguide, the silica optical waveguide has a specific size greater than that of the semiconductor waveguide region. As a mounting substrate on which the silica optical waveguide is to be mounted, a silicon substrate is optimum from the standpoint of practical use. By forming a groove on a silicon substrate by etching utilizing the anisotropy of a crystal lattice of silicon, the optical waveguide can be held very well. Further, the alignment of the optical axes of the semiconductor waveguide region and the second optical feedback means can also be made with high accuracy, and a difference in size between the members can be easily adjusted.

A diffraction grating is usually formed on the silica optical waveguide fabricated on the silicon substrate by directing ultraviolet radiation to obtain a mounting substrate for the semiconductor waveguide region.

The emission region is formed by a usual technique according to an oscillation wavelength required by the light source. The emission region may have various specific structures according to required characteristics, such as a single-quantum well structure, multi-quantum well structure, or strained quantum well structure.

A practical example of the optical waveguide having the spot enlarging function is a thick-film tapered waveguide formed by gradually reducing a core film thickness of the laminate of multi-quantum well waveguides toward its either end surface. In general, the thickness of the thick-film tapered waveguide is set in the range of about 50 nm to about 200 nm, and the length of the thick-film tapered waveguide is set to about 200 µm. This spot enlarging portion is referred to as a waveguide lens, and the use of the waveguide lens can greatly improve an optical coupling efficiency in the optical system.

### (First Preferred Embodiment)

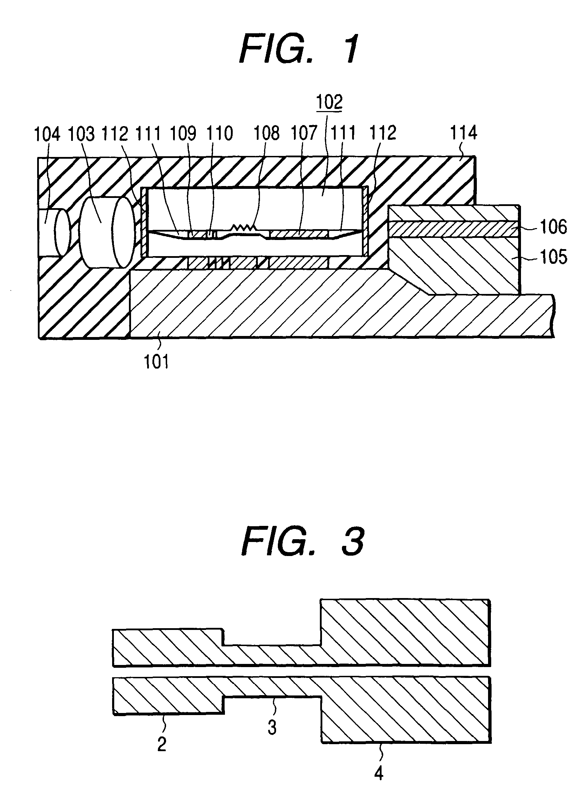

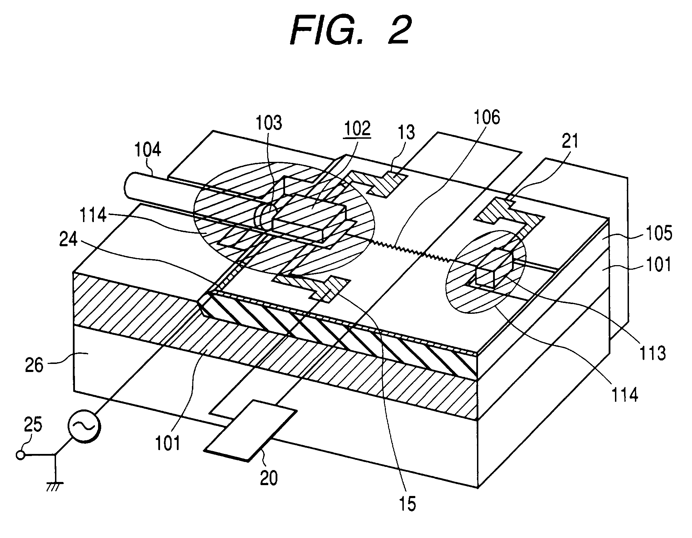

A preferred embodiment of the optical transmitter having the optical modulator built-in light source according to the present invention will now be described with reference to FIGS. 1 and 2. FIG. 1 is a schematic sectional side view of the optical transmitter, and FIG. 2 is a perspective view of the optical transmitter. More specifically, FIG. 1 is a cross section taken along a plane parallel to the optical axis of the light source shown in FIG. 2. The optical modulator built-in light source has a wavelength band of 1.55 µm, for example.

As shown in FIGS. 1 and 2, a semiconductor optical element section 102 is mounted on a mounting substrate 101. An optical transmission line 104 is provided so as to face one end surface of the semiconductor optical element section 102, and a diffraction grating 106 as the second optical feedback means is provided so as to face the other end surface of the semiconductor optical element section 102. The diffraction grating 106 is independent of the semiconductor optical element section 102. The diffraction grating 106 and a distributed Bragg reflector waveguide 108 as the first optical feedback means in the semiconductor optical element section 102 constitute a laser resonator. In this sense, it can be said that the light source in the present invention is a modulator integrated compound cavity laser configured by integrating an optical modulator with an external reflector laser.

An optical isolator 103 is discretely inserted between the semiconductor optical element 102 and the optical transmission line 104. The optical isolator 103 may be integrated with the semiconductor optical element section 102 and the optical transmission line 104. In many cases, the optical transmission line 104 is provided by an optical fiber. In many cases, the semiconductor optical element section 102 and the optical transmission line 104 are fixed through a resin 114 to the mounting substrate 101. In the case that the resin 114 is inserted between the semiconductor optical element section 102, the optical transmission line 104, and the optical isolator 103, a transparent resin having desired optical characteristics is used as the resin 114.

As shown in FIG. 2, a photodetector 113 such as a photodiode for monitoring the wavelength of incident light is provided so as to face one end of the diffraction grating 106. A deviation of the oscillation wavelength can be monitored by an optical output from the photodetector 113 because wavelength selection is carried out by the diffraction grating 106. The photodetector 113 is also fixed through the resin 114 to the mounting substrate 101.

The mounting substrate 101 is preferably formed of silicon. A silica optical waveguide 105 is mounted on the upper surface of the mounting substrate 101. By forming a groove on the silicon substrate by etching utilizing the anisotropy of crystal lattice of silicon, the optical waveguide can be held very well. The silica optical waveguide 105 is partially formed with the diffraction grating 106 having a period of 0.54 µm. The diffraction grating 106 has a Bragg wavelength of 1552 nm and a stop band width of about 0.3 nm.

The semiconductor optical element section 102 is mounted on the mounting substrate 101 by a so-called junction-down mounting method such that the upper surface of the semiconductor optical element section 102 is opposed to the upper surface of the mounting substrate 101. The semiconductor optical element section 102 has a plurality of multi-quantum well waveguides in the form of laminate, which is configured by InGaAsP layers formed on an InP substrate. The laminate of multi-quantum well waveguides has at least (1) an emission region 107 including an active layer, (2) a distributed Bragg reflector waveguide 108, (3) an optical absorption layer 109, and (4) an optical absorption layer 110 for optical output control. In many cases, the optical absorption layers 109 and 110 are configured as the same region.

The above-mentioned regions have the following characteristics. The emission region 107 has an emission peak near a wavelength band of 1560 nm. The distributed Bragg reflector wavelength 108 has an emission peak near a wavelength band of 1400 nm, and has a diffraction grating having a Bragg wavelength of about 1552 nm and a stop band width of 4 to 6 nm. The optical absorption layer 109 has an emission peak near a wavelength band of 1500 nm. The optical absorption layer 110 has an emission peak near a wavelength band of 1500 nm. Practically, a pair of thick-film tapered waveguides 111 are formed by monolithic integration as spot enlarging portions near the opposite ends of the laminate. Each thick-film tapered waveguide 111 has a structure such that the core film thickness of each waveguide 111 is gradually reduced toward its either end. These spot enlarging portions can improve an optical coupling efficiency in the optical system. For example, the optical coupling efficiency between the semiconductor optical element section 102, the optical fiber 104, and the silica optical waveguide 105 can be improved up to about 60 % by adopting the spot enlarging portions. Further, a pair of antireflection coatings 112 each having a reflectivity of 0.02 % or less are formed on the opposite end surfaces of the semiconductor optical element section 102.

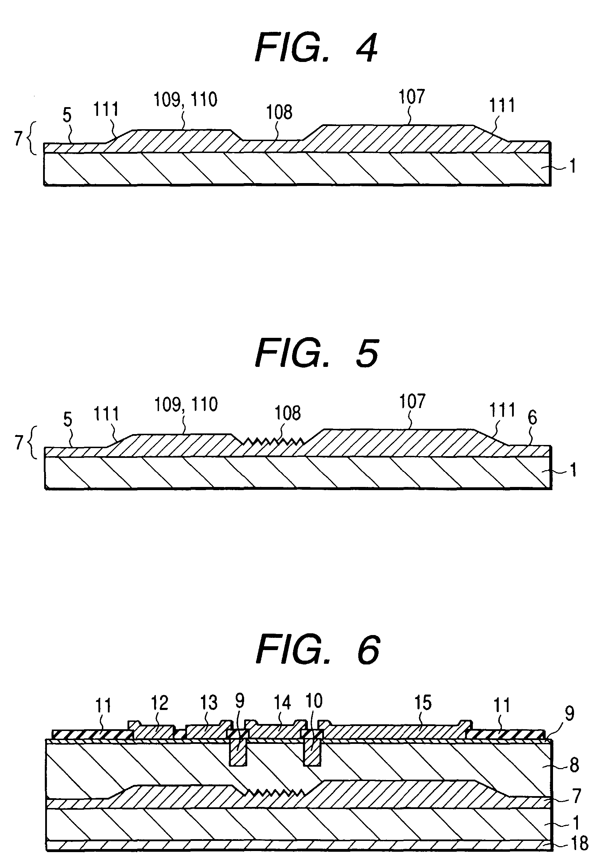

A fabrication process for the laminate of multi-quantum well waveguides mentioned above will now be described with reference to FIGS. 3 to 7. FIG. 3 is a plan view of a mask for selective growth in forming a multi-quantum well structure by crystal growth. FIGS. 4 to 7 are sectional views for illustrating the steps of the fabrication process for the laminate of multi-quantum well waveguides. Each sectional view is a cross section taken along a plane parallel to the optical axis of the laminate.

The mask for selective growth shown in FIG. 3 is formed by a silicon dioxide (SiO₂) film, for example, on a given semiconductor substrate 1 such as an n-type InP substrate to be subjected to crystal growth. The upper surface of the semiconductor substrate 1 coincides with a (100) plane. In FIG. 3, the mask for selective growth is composed of a region 2 corresponding to the optical absorption region for forming an optical modulator, a region 3 corresponding to the first optical feedback means for forming a diffraction grating, and a region 4 corresponding to the emission region.

It is generally known that the thickness of a semiconductor layer to be subjected to selective growth can be controlled according to the width of a mask. The selective growth in this preferred embodiment uses this principle to control the film thickness of each region. A technique for such selective growth is described in detail in International Journal of High Speed Electronics and Systems, Vol. 5, No. 1, (1994) 67-90, for example. In this preferred embodiment, the width of a mask opening corresponding a region for forming a wavelength is set in the range of about 10 µm to about 30 µm, and the half widths of the regions 2, 3, and 4 of the mask are set to 30 µm, 10 µm, and 60 µm, respectively.

A multi-quantum well structure 7 is formed by MOCVD (Metalorganic Chemical Vapor Deposition) known in the art, using the above-mentioned mask for selective growth. The material of the multi-quantum well structure 7 is InGaAsP. The multi-quantum well structure 7 is similar to a usual structure, and the details of the structure are therefore not shown in FIGS. 4 to 7. Each well layer of the multi-quantum well structure 7 has a composition wavelength of 1.7 µm, and each barrier layer of the multi-quantum well structure 7 has a composition wavelength of 1.3 µm. The well layers and the barrier layers are formed with 8 periods. As the result of the selective growth using the mask, the film thickness of the optical absorption regions 109 and 110 corresponding to the region 2 of the mask is 0.25 µm; the film thickness of the distributed Bragg reflector waveguide region 108 corresponding to the region 3 of the mask is 0.1 µm; and the film thickness of the active layer region 107 corresponding to the region 4 of the mask is 0.3 µm. Further, the thickness of end regions 5 and 6 of the multi-quantum well structure 7 is 0.05 µm for each. FIG. 4 show the result of this selective growth.

In the next step, a diffraction grating is formed in the distributed Bragg reflector waveguide region 108 by a known method as shown in FIG. 5. The diffraction grating in the region 108 has an emission peak near a wavelength band of 1400 nm. The Bragg wavelength of the diffraction grating is about 1552 nm, and the stop band width of the diffraction grating is in the range of 4 nm to 6 nm.

Each of the optical absorption regions 109 and 110 has an emission peak near a wavelength band of 1500 nm. The optical absorption region 109 is a monitoring region, and the optical absorption region 110 is an optical output control region. The emission region 107 has an emission peak near a wavelength band of 1560 nm.

As shown in FIG. 6, a p-type InP layer 8 having a thickness of about 3 µm and a p-type InGaAs layer 9 having a thickness of about 0.2 µm are crystal-grown by a known method on the semiconductor substrate having the multi-quantum well structure 7 mentioned above. Further, the opposite sides of these layers 8 and 9 in a direction crossing the optical axis of the multi-quantum well laminate are formed by a so-called buried heterostructure. The material of the buried heterostructure is high-resistance InP doped with Fe, and the thickness of the buried heterostructure is set to about 5 µm. To isolate the regions 2, 3, and 4 from each other, high-resistance regions 16 and 17 are formed in these layers 8 and 9 by proton implantation. Further, a silicon dioxide layer 11 as a passivation film is formed on the layer 9 so as to cover the upper surfaces of the high-resistance regions 16 and 17. Thereafter, given electrodes 12, 13, 14, and 15 as a first electrode are formed through the silicon dioxide layer 11 so as to be opposed to the optical absorption region 110, the optical absorption region 109, the diffraction grating region 108, and the emission region 107, respectively. The material of these electrodes 12, 13, 14, and 15 is TiPtAu in this preferred embodiment. That is, the electrode 12 is an electrode for optical output control; the electrode 13 is an electrode for optical output monitoring; the electrode 14 is an electrode for wavelength turning used in the case of requiring the control of the Bragg wavelength of the diffraction grating; and the electrode 15 is an electrode for the emission region.

Further, a second electrode 18 of AuGe, for example, is formed on the lower surface of the semiconductor substrate 1 (see FIG. 6).

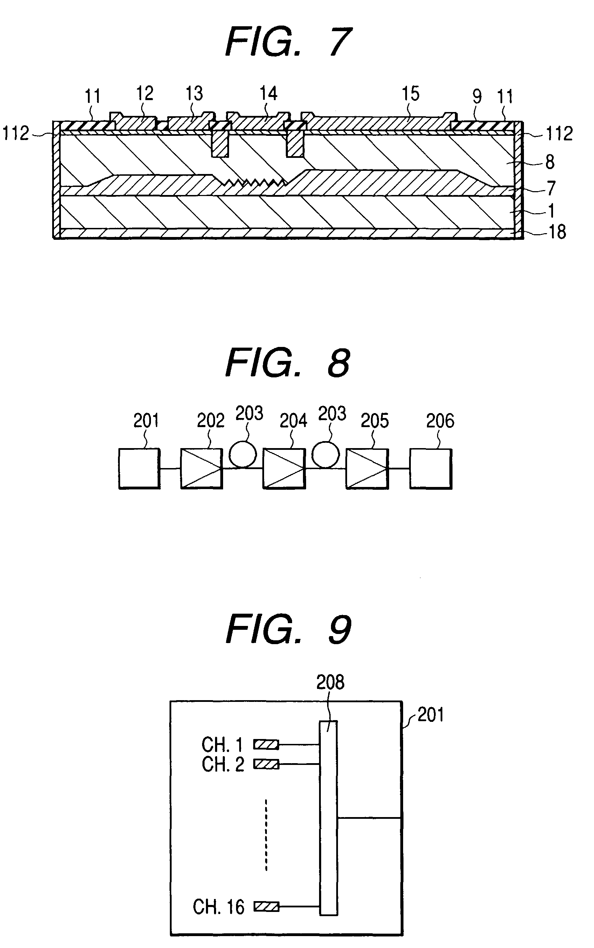

As shown in FIG. 7, known AR (antireflection) coatings 112 of silicon nitride (SiNx) are formed on the optical output opposite end surfaces of the multi-quantum well structure. Each AR coating 112 has a reflectivity of 0.02 % or less.

As shown in FIG. 2, the photodetector 113 such as a photodiode for optical output monitoring is located at a rear end portion of the silica optical waveguide 105. All the optical components are embedded in the resin 114 having a refractive index of about 1.4, thereby preventing the reflection of light on the end surface of each optical component.

The laser cavity is configured by the silica optical waveguide 105 having a diffraction grating, the emission region 107 including an active layer, and the distributed Bragg reflector waveguide 108. Laser light emitted from the laser cavity is passed through the optical absorption region 109 and modulated therein. Then, the modulated light is led through the thick-film tapered waveguide 111 and the optical isolator 103 to the optical fiber 104.

As shown in FIG. 2, the semiconductor optical device as configured above is mounted on a Peltier element 22 as temperature control means for controlling the temperature of the laser cavity. The optical output control electrode 12 is provided for optical modulation. The optical output monitor electrode 13 is provided for optical output monitoring. The emission region electrode 15 is provided for oscillation output control. FIG. 2 schematically shows the connection between the semiconductor optical device and an external circuit.

A modulating signal is applied from an external signal source 25 to the optical output control electrode 12. A monitor signal from the optical output monitor electrode 13 is transmitted to a control circuit 20. The control circuit 20 generates a control signal to the emission region electrode 15 to thereby control the oscillation output to a desired optical output. On the other hand, the laser light subjected to wavelength selection by the diffraction grating 106 is supplied to the photodetector 113. An output signal from the photodetector 113 is transmitted through a signal electrode 21 to the Peltier element 22. Then, the Peltier element 22 performs temperature control according to the detected signal from the photodetector 113 to thereby control the oscillation wavelength of the laser.

The laser oscillation wavelength is determined by phase conditions of the diffraction grating 106, the distributed Bragg reflector wavelength 108, and the laser cavity. Accordingly, the oscillation wavelength tends to have a distribution from the standpoint of fabrication. This wavelength distribution is affected by a stop band width. The stop band width is determined by the diffraction grating 106 on the silica optical waveguide. In this preferred embodiment, the stop band width is set to a small value of about 0.3 nm. Therefore, the wavelength distribution can be suppressed to such a small range. As compared with a conventional simple semiconductor laser device, fluctuations in the oscillation wavelength can be greatly reduced. In addition, the optical modulator is monolithically integrated with the semiconductor laser device in this preferred embodiment, low-chirp modulation can be easily realized. The low-chirp modulation means optical modulation with the wavelength chirping reduced.

Accordingly, it is possible to easily realize simplification of wavelength setting, high-speed transmission, and long-haul transmission in a wavelength division multiplexing optical communication system.

### (Second Preferred Embodiment)

A wavelength division multiplexing optical transmission system adopting the present invention will now be described with reference to FIGS. 8 and 9. FIG. 8 is a block diagram showing a general configuration of the wavelength division multiplexing optical transmission system, and FIG. 9 is a plan view showing an internal configuration of a wavelength division multiplexing optical transmitting section in the wavelength division multiplexing optical transmission system shown in FIG. 8.

The wavelength band used in this preferred embodiment is a 1.55 µm band. As shown in FIG. 8, the wavelength division multiplexing optical transmission system of the preferred embodiment includes a wavelength division multiplexing optical transmitting section 201, an optical preamplifier 202, an optical fiber 203, an in-line amplifier 204, an optical postamplifier 205, and an optical receiving section 206. Of these components, the wavelength division multiplexing optical transmitting section 201 is characteristic of this preferred embodiment, and the other components may be configured by usual components. Accordingly, the detailed description of the components other than the wavelength division multiplexing optical transmitting section 201 will be omitted herein.

As shown in FIG. 9, the wavelength division multiplexing optical transmitting section 201 is composed of at least a plurality of optical modulator integrated light sources 207 and a multiplexer 208. Each light source 207 is similar to the optical transmitter of the first preferred embodiment, and the internal configuration of each light source 207 is designed so as to adapt to a given oscillation wavelength to be hereinafter illustrated. The oscillation wavelengths of the light sources 207 are set according to the characteristics of diffraction gratings and the selection of emission layer materials, while many fine wavelength differences are set according to the design of diffraction gratings.

The light sources 207 are individually provided as illustrated by Ch. 1 to Ch. 16 in FIG. 9. The oscillation wavelengths of the light sources 207 are set in the range of 1533.47 nm to 1557.36 nm, and the wavelength spacing is set to 1.6 nm. The light sources 207 generate modulated optical signals having different wavelengths and supply them into the multiplexer 208. The multiplexer 208 functions to wavelength division multiplex the optical signals supplied from the light sources 207. The multiplexer 208 may be configured by a usual multiplexer. The wavelength division multiplexed optical signals from the multiplexer 208 are transmitted to the optical preamplifier 202 shown in FIG. 8.

An optical output from each light source 207 is maintained at a constant value by feeding back a monitored value of the optical output to a voltage value applied to the optical output controlling optical absorption region incorporated in each light source.

In the above optical transmission system, a drive current for the laser is not increased even in the case of aged deterioration of the semiconductor laser device as each light source. Accordingly, wavelength fluctuations due to an increase in Joule heat do not occur, thereby ensuring wavelength stability in each channel.

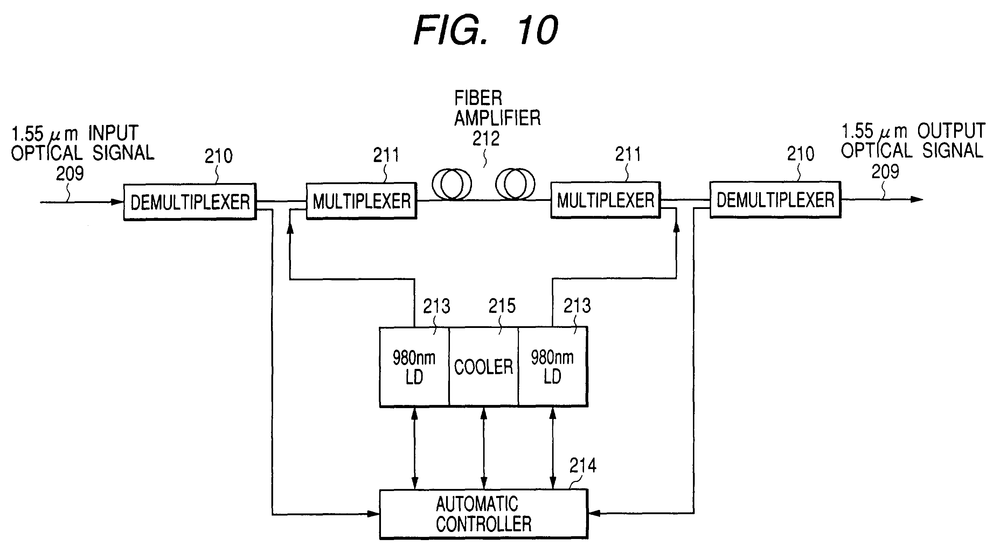

A bidirectional optical transmission system using the optical transmitter according to the present invention will now be described with reference to FIG. 10. FIG. 10 is a schematic block diagram of a typical bidirectional optical transmission system to which the present invention is applicable. Reference numeral 209 denotes an optical input of wavelength division multiplexing optical signals. The optical input 209 is supplied to a demultiplexer 210 to obtain signal light having a given wavelength. The optical input 209 is generated by using the above-mentioned wavelength division multiplexing optical transmitter. A semiconductor laser device 213 is provided to generate pump light for pumping a fiber amplifier 212. The signal light from the demultiplexer 210 and the pump light from the semiconductor laser device 213 are coupled by a coupler 211 to enter the fiber amplifier 212, thereby amplifying the signal light. The semiconductor laser device 213 is generally cooled by a cooling device 215, and these devices 213 and 215 are controlled by an automatic control unit 214.

Generally, on the transmitting side, a plurality of channels are allocated along a frequency axis to carrier waves modulated by original information (signals) and the transmission signals of the channels are combined together by an optical multiplexer. On the receiving side, the multiplexed signals are frequency-divided into individual signals by an optical demultiplexer, and each individual signal is passed through an optical detector/demodulator circuit to reproduce the original information. Such bidirectional transmission is performed by using a single optical fiber.

The present invention may be applied also to any optical systems and optical communication systems.

By using the optical transmitter according to the present invention, highly reliable wavelength division multiplexing transmission can be realized. Further, the wavelengths of optical signals of all channels can be stabilized by a greatly simple method, and highly reliable wavelength division multiplexing transmission can be realized at a low cost.

By using the wavelength division multiplexing communication device according to the present invention, high-quality signal transmission with uniform interchannel signal quality can be realized by a simple method. In particular, even in the case of aged deterioration of a semiconductor laser as the transmitter light source, the wavelengths of multiplexed signal light are unchanged, thus easily realizing a highly reliable optical transmitter at a low cost.

According to the present invention, it is possible to provide an optical transmission system having a light source whose oscillation wavelength is stable.

According to the present invention, it is possible to provide an optical transmitter suitable for a transmission system and includes an external modulator monolithically integrated.

## Claims

1. An optical transmission system having an optical transmitter as a light source, said optical transmitter comprising:
a semiconductor waveguide region comprising distributed reflection type first optical feedback means, an emission region, and an optical absorption region integrated together; and
second optical feedback means formed independently of said semiconductor waveguide region in opposed relationship to an end surface of said semiconductor waveguide region opposite to said first optical feedback means;
optical modulation being performed in said optical absorption region.

2. An optical transmission system having a plurality of optical transmitters as light sources for wavelength division multiplexing of optical signals having at least two different wavelengths, each of said optical transmitters comprising:
a semiconductor waveguide region comprising distributed reflection type first optical feedback means, an emission region, and an optical absorption region integrated together; and
second optical feedback means formed independently of said semiconductor waveguide region in opposed relationship to an end surface of said semiconductor waveguide region opposite to said first optical feedback means;
optical modulation being performed in said optical absorption region.

3. An optical transmission system according to claim 1 or 2, wherein the width of a stop band of said second optical feedback means is smaller than the width of a stop band of said first optical feedback means.

4. An optical transmitter comprising:
a semiconductor waveguide region comprising distributed reflection type first optical feedback means, an emission region, and an optical absorption region integrated together;
second optical feedback means formed independently of said semiconductor waveguide region in opposed relationship to an end surface of said semiconductor waveguide region opposite to said first optical feedback means; and
a given substrate on which said semiconductor waveguide region and said second optical feedback means are mounted;
optical modulation being performed in said optical absorption region;
the width of a stop band of said second optical feedback means being smaller than the width of a stop band of said first optical feedback means.

5. An optical transmitter according to claim 4, wherein said semiconductor waveguide region is a laminate of semiconductor waveguides, said laminate having input and output ends at least one of which is provided with an optical waveguide having a spot enlarging function.
